(19)

Europäisches
Patentamt

European
Patent Office

Office européen
des brevets

(11)  **EP 1 847 838 B1**

(12)  **EUROPEAN PATENT SPECIFICATION**

(45) Date of publication and mention
of the grant of the patent:
**16.09.2009  Bulletin 2009/38**

(51) Int Cl.:
***G01R 23/16*** *(2006.01)*

(21) Application number: **07002105.0**

(22) Date of filing: **31.01.2007**

(54) **Method and apparatus for frequency estimation**

Verfahren und Vorrichtung zur Frequenzschätzung

Procédé et appareil d'éstimation de fréquence

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **21.04.2006  EP 06008339**

(43) Date of publication of application:
**24.10.2007  Bulletin 2007/43**

(73) Proprietors:
• **Fondazione Torino Wireless
10129 Torino (IT)**
• **POLITECNICO DI TORINO
10129 Torino (IT)**
• **Istituto Superiore Mario Boella
10138 Torino (IT)**

(72) Inventors:
• **Lo Presti, Letizia
10138 Torino (IT)**

• **Borio, Daniele
10093 Collegno (TO) (IT)**
• **Camoriano, Laura
10073 Ciriè (TO) (IT)**
• **Del Pero, Emanuele
10138 Torino (IT)**
• **Grignani, Elisabetta
10132 Torino (IT)**

(74) Representative: **Grünecker, Kinkeldey,
Stockmair & Schwanhäusser
Anwaltssozietät
Leopoldstrasse 4
80802 München (DE)**

(56) References cited:
**EP-A- 1 215 824        US-A- 5 640 431
US-A1- 2002 084 933**

EP 1 847 838 B1

**Description**

FIELD OF THE PRESENT INVENTION

The present invention relates to the art of signal tracking in communication and navigation systems and, in particular, the determination and tracking of the carrier frequency of a noisy modulated spreaded communication signal by means of a Frequency Lock Loop technique.

DESCRIPTION OF THE PRIOR ART

An important issue of signal processing, in general, is the accurate determination of the frequencies and phases of transmitted and received signals. The correct estimation of parameters of signals, as the frequency and phase, e.g., of single- or multiple-frequency tones from a finite time-discrete sample may, e.g., be necessary in the context of the identification of sinusoidal components of an audio signal, synchronization in telecommunication systems or the frequency tracking in power networks.

In many feedback control systems a generated signal has to be maintained in a fixed phase relationship and/or at an accurately determined frequency as, e.g., in frequency synthesizers for digitally tuned radio receivers, in lock-in amplifiers or dual tone multifrequency dialing decoders.

In the field of navigation/localization systems Global Navigation Satellite Systems (GNNS), as the Global Positioning System (GPS) and the European Galileo, are of growing importance. A GPS receiver, e.g., must be able to track the spread-spectrum signals, i.e. phase-modulated signals using bi-phase shift keying (BPSK) that it receives from GPS satellites with high accuracy. During the acquisition phase the carrier frequency and the phase angle of the coarse/acquisition (C/A code), for civil purposes, has to be determined. Accurate tracking of the carrier frequency and the Doppler shift caused by the relative velocity of the satellite with respect to the receiver are mandatory for an accurate determination of the position and velocity of the receiver. The Doppler shift is usually determined from the phase of the carrier signal. The maximum Doppler frequency for the L1 GPS signal having a frequency of 1575.42 MHz is about 5 kHz (for terrestrial applications).

When the carrier frequency changes, the receiver may loss track of the satellite signal. Whereas ideally the carrier frequency is known, due to noise and the satellite motion the actual carrier frequency is slightly different from the set value. This difference can be modeled as a time-varying phase.

In addition to Doppler shift, noise in form of white Gaussian noise introduces random perturbations in the phase and amplitude of the carrier and, thus, the prediction of the carrier phase is, in principle, uncertain.

Standard receivers track the C/A code phase by a Delay Locked Loop (DLL) and the carrier phase by a Phase Locked Loop (PLL). An apparatus employing both loops, called a signal tracking loop, is disclosed in US 5 222 843. Both loops represent feedback loops that align replica signals in the receiver with the actual received signal.

Typically, a PLL, usually in form of a Costas loop, consists of a numerically controlled oscillator, a carrier loop filter and a discriminator. The output of the discriminator is used to control the oscillator tuning the oscillation frequency so that the loop can continuously demodulate the received satellite signal. On the basis of the despreaded C/A code the signal output by the oscillator usually has both (inphase) I and (quadrature) Q channels. After correlating with the input signal the signal from each channel is lowpass filtered.

The above described conventional acquisition process includes, however, a high complexity and also demands for relatively powerful computer resources. Robustness of the conventional method might also be improved. Thus, it is the problem underlying the present invention to provide a more reliable and fast method for estimating the frequency of a received signal and a receiver employing such a method.

SUMMARY OF THE PRESENT INVENTION

The above-mentioned problem is solved by a method according to claim 1. The inventive method for estimating the frequency $f_x$ of a periodic input signal $x_{in}$, comprises

performing a Discrete Time Fourier Transform of N first time-discrete samples x of the input signal $x_{in}$, N being an integer $\geq 1$, to obtain a first transformed signal $X_1$;

performing a Discrete Time Fourier Transform of N second time-discrete samples $x_L$ of the input signal $x_{in}$ time-delayed by L samples with respect to the first time-discrete samples x, L being an integer $\geq 1$, to obtain a second transformed signal $X_2$;

calculating the phase $\varphi_r$ of the ratio r of the second transformed signal $X_2(f)$ and the first transformed signal $X_1(f)$ at one single pre-selected frequency f;

determining an estimate $\hat{f}_x$ for the frequency $f_x$ of the periodic input signal $x_{in}$ on the basis of the phase $\varphi_r$ of the ratio of the second transformed signal $X_2(f)$ and the first transformed signal $X_1(f)$ at the pre-selected frequency f; and

generating an output signal on the basis of the estimate $\hat{f}_x$ for the frequency $f_x$.

For fast performance, the estimate $\hat{f}_x$ for the frequency $f_x$ of the periodic input signal $x_{in}$ is iteratively calculated and the output signal is generated on the basis of the iteratively calculated values for $\hat{f}_x$. The output signal may be the estimated frequency itself to be used, e.g., in a signal/data acquisition and tracking systems.

With the discrete time index n the digital input signal, which may be a sinusoidal signal, can be written as proportional to $\cos(2\pi f_x n + \varphi)$, where $\varphi$ is the phase of the signal. The N first time-discrete samples of the input signal $x_{in}$ define a vector $\mathbf{x} = (x_{in}(0), x_{in}(1), .., x_{in}(N-1))$. Time-delaying of $\mathbf{x}$ by L (L being an integer $\geq$ 1 in particular, L may be chose to be equal or less than N) results in further N time-discrete samples $\mathbf{x}_L = (x_{in}(L), x_{in}(L+1), .., x_{in}(L+N-1))$. At a frequency f the Discrete Time Fourier Transform (DTFT) can be evaluated, respectively, by

$$X_1(f) = \sum_{n=0}^{N-1} x_{in}(n)\exp(-i2\pi f n) \quad ; \quad X_2(f) = \sum_{n=0}^{N-1} x_{in}(n+L)\exp(-i2\pi f n).$$

According to the disclosed method two DTFTs are carried out over overlapping data segments. The complex ratio $r = X_2(f) / X_1(f)$, where $X_1$ and $X_2$ are taken at the same single frequency, can be expressed by means of an amplitude $m_r$ and a phase $\varphi_r$: $r = m_r \exp(i\,\varphi_r(f))$. The phase $\varphi_r$ not only includes information on the frequency f, but $g(f_x, f_x) := \varphi_r / 2\pi L$ actually represents a fixed point mapping for $f = f_x$ and, thus, the frequency $f_x$ to be determined from the input signal $x_{in}$ can, in principle, be estimated based on the phase $\varphi_r$.

As discussed in more detail in the detailed description of examples of the present inventive method below, by this example of the inventive method the same fixed point mapping can be incorporated whether or not the desired frequency $f_x$ of the input signal can actually be written as the ratio of some integer and the length N of the sample vectors x and $\mathbf{x}_L$.

Since the calculation of the ratio $X_2(f) / X_1(f)$ and the phase $\varphi_r$ can easily be performed with relatively low-performance computer facilities the present invention provides a method for the estimation of the frequency of an input signal that is less computer time and memory consuming than known in the art. In particular, the fixed point mapping allows for an iterative solution approach $\hat{f}_{x,i+1} = g(\hat{f}_{x,i}, f_x)$, i.e. a fixed point iteration, where the index i counts the iteration and the circumflex denotes the estimate for the real frequency $f_x$ of the input signal $x_{in}$ (see also discussion below). Iteration procedures can be performed very fast and robust algorithms are available that do not require for high-performance computer facilities. Thus, the desired frequency can be estimated very quickly. The output signal can, e.g., be identical to the solution of the fixed point mapping, in particular, to the final calculated iteration

$$\hat{f}_{x,F} = g(\hat{f}_{x,F-1}, f_x) = \frac{\varphi_{r,F}}{2\pi L} \;,$$ if, e.g., F iterations have been performed. In receivers for Global Navigation Satellite Systems, e.g., the output signal can be used for carrier tracking.

The first estimate, i.e. the initial value, of the iteration $\hat{f}_{x,0}$ for estimating the frequency $f_x$ of the periodic input signal $x_{in}$ can be calculated by means of a Fast Fourier Transform (FFT). The frequency corresponding to the peak of the respective Fourier spectrum represents the initial value.

Some acquisition means as known in the art may receive and sample a transmitted signal to generate the input signal $x_{in}$. The acquisition means may provide a rough estimate $f_{ac}$ for the frequency $f_{in}$. The search for the peak in the Fourier transformed spectrum of a segment of the input signal or for the peak in segments of the Fourier transformed spectrum of the input signal may be performed in a limited frequency interval given by the size of the frequency bin provided by the acquisition means in order to avoid locking at a false peak. For a bin size of B the search can be limited to the interval $[f_{ac} - B, f_{ac} + B]$. Alternatively, a rough estimate can be given by the frequency that is a priori expected for the transmitted signal (as, e.g., 1575,42 MHz for the carrier frequency of the L1 signal of the GPS L band).

The use of the FFT allows for employing very fast and robust algorithms. In particular, according to the inventive method the iterative procedure allows for the evaluation of a long data segment without the need for an extensive FFT (see below). Several DTFTs are performed rather than one single long FFT, as it is necessary in the art, whereby the estimate for the desired frequency $f_x$ of the input signal $x_{in}$ is obtained unusually fast. To calculate the first estimate of the iteration $\hat{f}_{x,0}$ for the frequency $f_x$ of the periodic input signal $x_{in}$ by seeking for the peak of the Fast Fourier Transform in an interval ranging from one acquisition frequency bin below a rough estimate for the frequency $f_x$ of the periodic input signal $x_{in}$ to one acquisition frequency bin above the rough estimate for the frequency $f_x$ of the periodic input signal $x_{in}$ guarantees robustness of the proposed method.

If the noise that usually is present in the input signal $x_{in}$ is high, i.e. if the signal-to-noise ratio of the carrier is low, there could be a leap $\Delta$ in the estimated frequency, i.e. a finite difference between the estimated frequency and the actual one of the input signal, that depends on the number of samples L the second time-discrete samples $\mathbf{x}_L$ are time-delayed with respect to the first time-discrete samples $\mathbf{x}$ of the input signal $x_{in}$. Thus, a procedure may be included that determines which of the values $\hat{f}_x$ and $\hat{f}_x \pm \Delta$ is closest to, e.g., the acquisition frequency $f_{ac}$ mentioned above or some different rough estimate of the frequency $f_x$ of the input signal $x_{in}$.

Consequently, the inventive method may advantageously comprise the step of comparing the estimated frequency $\hat{f}_x$, $\hat{f}_x - \Delta$ and $\hat{f}_x + \Delta$, where $\Delta$ denotes some frequency leap, with a rough estimate for the frequency $f_x$ of the periodic input signal $x_{in}$ or with the first estimate of the iteration $\hat{f}_{x,0}$ for the frequency $f_x$ of the periodic input signal $x_{in}$ and the output signal can be generated on the basis of the comparison result. If, e.g., $\hat{f}_x + \Delta$ is closest to the rough estimate, this frequency will be chosen to be the estimate for the frequency $f_x$ and in this case the output signal will include information about this frequency.

If the iteration procedure for estimating the frequency $f_x$ includes i iterations, i ratios $r_i$ of respective second transformed signals $X_{L,i}(f)$ obtained by Discrete Time Fourier Transforms of N second time-discrete samples $\mathbf{x}_{L,i}$ delayed by L samples with respect to N first time-discrete samples $\mathbf{x}_i$ and respective first transformed signals $X_i(f)$ obtained by Discrete Time Fourier Transforms of N first time-discrete samples $\mathbf{x}_i$ for a frequency f that is equal to the estimation $\hat{f}_{x,i-1}$ of the frequency $f_x$ of the periodic input signal $x_{in}$ at the (i - 1 ) - th iteration are calculated. In form of a symbolic formula this calculation is expressed by $r_i = \{DTFT(\mathbf{x}_{L,i}) / DTFT (\mathbf{x}_i)\}|\ f = \hat{f}_{x,i-1}$. Moreover, i phase values $\varphi_{r,i}$ for the respective i ratios can be calculated and an i-th frequency estimation $\hat{f}_{x,i}$ can be calculated by $\hat{f}_{x,i} = \dfrac{\varphi_i}{2\pi L}$ . The latter expression can subsequently be used for the i+1-th frequency estimation $\hat{f}_{x,i+1}$ to be calculated from $\hat{f}_{x,i+1} = g(\hat{f}_{x,i}, fx)$. By employing this iteration procedure a Frequency Lock Loop can be established.

By this iteration procedure long data segments can be evaluated without the need for long FFTs. Several relatively short DTFTs that are evaluated at one single frequency, respectively, are employed rather than an exhaustive FFT. It should be noted that different noise samples are present at each step of the iteration procedure.

Due to the elimination of multiples of $2\pi$ the problem of phase ambiguities arises when employing the angle operator. This problem can be solved by adding a correction term to the estimated frequency, in particular, by adding a term round($\hat{f}_{x,0}$ L) that takes into account the integer number of $2\pi$ - number of cycles.

According to an alternative of the above-described example for estimating the frequency that makes use of the explained fixed point mapping, it can be taken advantage of the fact that the maximum likelihood phase of signal samples can readily obtained and incorporated in the inventive method. The maximum likelihood phase $\hat{\varphi}$ of input signal samples x is simply given by the angle (phase) of the Discrete Time Fourier Transform of the input signal samples x at a predetermined frequency, i.e. $\hat{\varphi}$ = angle $\{DTFT_N \{x\}_f\}$. Accordingly, another example of the inventive method further comprises the steps of

determining the maximum likelihood estimation for the phase $\hat{\varphi}_{1,i}$ of the first time-discrete samples (x) of the input signal $(x_{in})$;

determining the maximum likelihood estimation for the phase $\hat{\varphi}_{2,i}$ of the second time-discrete samples $(x_L)$ of the input signal $(x_{in})$;

and wherein the i+1-th estimate for the frequency is determined according to

$$\hat{f}_{x,i+1} = \frac{1}{2\pi L}(\hat{\varphi}_{2,i} - \hat{\varphi}_{1,i})$$

where $\hat{\varphi}_{1,i}$ and $\hat{\varphi}_{2,i}$ are the angles of the Discrete Time Fourier Transform of the first and second time-discrete samples (x and $x_L$) of the input signal $(x_{in})$ for the frequency f = $\hat{f}_{x,i}$, respectively. Thus, the i+1-th estimate can efficiently be determined from two DTFTs each at a predetermined frequency given by the i-the estimate for the desired frequency.

In order to improve the estimate for the frequency $f_x$ of the input signal as well as the speed of iteration it might be helpful to filter the input signal $x_{in}$ by means of a noise reduction filtering means before performing the Discrete Time Fourier Transform of the N first time-discrete samples **x**.

Moreover, the input signal $x_{in}$ may be down-sampled before performing the Discrete Time Fourier Transform of the N first time-discrete samples **x** in order to reduce the complexity of the procedure of estimating the frequency $f_x$. The down-sampled signal may also be passed through a noise reduction filter. Furthermore, the input signal $x_{in}$ may be passed through a bandpass filter for anti-aliasing before it is down-sampled.

After completion of one of the above described examples of the iteration procedure a pre-selected number $M_L$ of iteratively calculated estimates $\hat{f}_{x,i}$ for the frequency $f_x$ of the periodic input signal $x_{in}$ may be sorted and the output value may be generated on the basis of the center value of the sorted estimates $\hat{f}_{x,i}$. This can be done by a median filter of length $M_L$. The finally estimated frequency, in this case, becomes the center value of the sorted estimates of the iteration procedure. The median filtering eliminates outliers of the estimate of the frequency $f_x$. Such outliers, however, are rare, if the signal-to-noise ratio of the carrier is sufficiently enhanced, e.g., by a noise reduction filtering means.

According to another example of the inventive method a mean value over a pre-selected time period of iteratively calculated estimates $\hat{f}_{x,i}$ for the frequency $f_x$ of the periodic input signal $x_{in}$ may be calculated. This may increase the accuracy of the finally estimated frequency, even if the convergence speed of the iteration procedure is low.

Moreover, different mean values of iteratively calculated estimates $\hat{f}_{x,i}$ may be calculated over different pre-selected time periods. Before calculating the mean values the iteratively calculated estimates $\hat{f}_{x,i}$ may be filtered by a median filter wherein the filtering comprises sorting a pre-selected number iteratively calculated estimates $\hat{f}_{x,i}$ for the frequency $f_x$ of the periodic input signal $x_{in}$ of values taken over pre-selected time periods.

The disclosed method can be advantageously applied in the context of signals received from a transmitter that moves relatively to a receiver and that, consequently, show some Doppler shift. The inventive method may, e.g., be employed in a GPS receiver.

Further, the method disclosed herein is particularly useful in the context of time-varying Doppler shifts. The application of several relatively short DTFTs instead of a long FFT allows for following time-varying Doppler shifts on very short time scales.

If the input signal $x_{in}$ is based on a signal generated by and received from a GPS satellite stripping of the C/A code and/or the P code before performing the Discrete Time Fourier Transform of the N first time-discrete samples x should be carried out. For example, the L1 signal sent by GPS satellites is binary phase shift keying (BPSK) modulated by the pseudo random noise (PRN) codes known as C/A code and the P code. In a GPS receiver employing examples of the above discussed examples the PRN codes are generated and used for the code stripping of the digital input signal representing the received GPS signal.

The inventive method can also be employed for obtaining positional information by Global Navigation Satellite Systems (GNSS) for very fast moving objects as, e.g., Low Earth Orbit satellites or sounding rockets. In this case, GNSS signals received by these fast moving objects are affected by quickly changing Doppler shifts and high Doppler shift rates. In order to deal with this problem it might be preferred to filter the estimate $\hat{f}_x$ for the frequency $f_x$ of the periodic input signal $x_{in}$ as obtained by one of the above-described examples by a Kalman filtering means as it is known in the art and to use the Kalman filtered frequency for the generation of the output signal.

The Kalman filtering may, in particular, be performed on the basis of the frequency evolution model

$$\begin{bmatrix} \overset{\vee}{\nu} \\ \Delta \nu \end{bmatrix}_{i+1} = \begin{bmatrix} 1 & 1 \\ 0 & 1 \end{bmatrix} \begin{bmatrix} \overset{\vee}{\nu} \\ \Delta \nu \end{bmatrix}_i + \mathbf{w}_i$$

and

$$\hat{f}_x = [1 \ 0] \begin{bmatrix} \overset{\vee}{\nu} \\ \Delta \nu \end{bmatrix}_i + \mathbf{v}_i$$

with the Doppler rates $\Delta v$ accounting for linear frequency variations and where $w_i = [w_{1,i}, w_{2,i}]$ denotes noise contribution $(w_{1,i})$ and random variation of the Doppler rate$(w_{2,i})$ and $v_l$ denotes a noise component due to estimation errors.

This means that the Kalman filter is designed by the evolution matrix $\begin{bmatrix} 1 & 1 \\ 0 & 1 \end{bmatrix}$ and the observation matrix [1 0].

It is also noted that the covariance matrix of $w_i$ as well as the variance of $v_k$ can be determined beforehand on the basis of the particular characteristics of the fast moving object and the variance of raw data for $\hat{f}_x$. Numerical experiments have proven that such a Kalman filter design is capable of a reliable tracking of fast moving objects with rapidly changing Doppler shifts.

The present invention provides a data acquisition apparatus configured to perform the steps of the above-described methods. In particular, the inventive apparatus may comprise or consist of a receiver, in particular a Global Positioning System receiver, or a frequency synthesizer for digitally tuned radio receivers and transmitters or a decoder for remote control and telecommunications. The inventive method is of particular use in the above mentioned systems that require an accurate and fast frequency tracking.

The above-mentioned system may comprise signal receiving and tracking units, filtering means as, e.g., low-pass filters, median filters operating as discussed above, noise reduction filters, a CPU for calculating, e.g., the frequency estimate of the input signal $x_{in}$ by means of the FFT and DTFT operations and the phase determinations of the ratios of the time-delayed vectors and the non-delayed vectors of N samples of the input signal as discussed above, etc. The tracking unit can be configured to track the input signal on the basis of an output signal generated by some means on the basis of the estimated frequency of the input signal. The apparatus may also comprise a means configured to receive an analogous signal and to analogue-to-digital convert this signal in order to obtain a digital input signal $x_{in}$.

Moreover, the apparatus may further comprise a Kalman filtering means, configured to filter the estimate for the estimate $(\hat{f}_x)$ for the frequency $(f_x)$ of the periodic input signal $(x_{in})$. The Kalman filtering means may operate as described above.

The inventive method can, in particular, advantageously be employed in a navigation system for a vehicle, as a car navigation system, allowing for acquisition and tracking of GPS data sent by GPS satellites. Since the computer resources of mobile GPS systems are limited, the efficiency of the inventive method can improve the reliability and overall performance of navigation systems installed in vehicles significantly. The same holds for handheld navigation systems.

The present invention further provides a computer program product, comprising one or more computer readable media having computer-executable instructions for performing the steps of the above-described methods.

Additional features and advantages of the present invention will be described with reference to the drawings. In the following description, reference is made to the accompanying figures that are meant to illustrate preferred embodiments of the invention. It is understood that such embodiments do not represent the full scope of the invention that is defined by the claims given below.

BRIEF DESCRIPTION OF THE DRAWINGS

Fig. 1 is a flowchart illustrating receiving and pre-processing of a periodic signal the frequency of which is to be estimated in accordance with the present inventive method.

Fig. 2 illustrates an example for the calculation of the first estimate for the frequency of a periodic input signal that is to be determined.

Fig. 3 illustrates the different data blocks used during the iteration procedure.

Fig. 4 illustrates basic steps of the disclosed method for estimating the frequency of a periodic input signal including an FFT of the input signal and DTFTs of sample vectors.

DETAILED DESCRIPTION

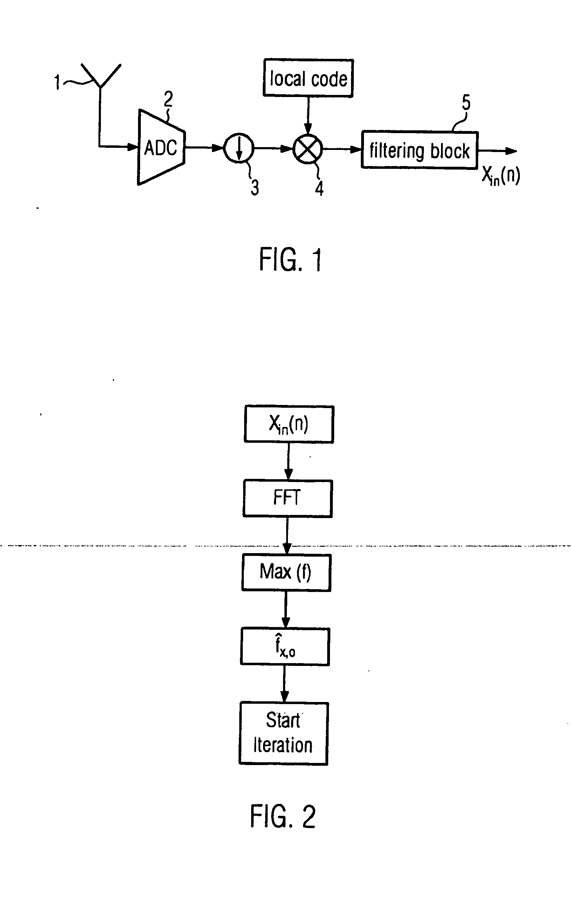

It is an object of the present invention to estimate the frequency $f_x$ of a periodic digital signal $x_{in}$ that ideally may be represented by $x_{in}(n) = A \cos(2\pi f_x n + \varphi)$, where $\varphi$ is the phase of the signal, n denotes the discrete time index and A is the amplitude. As shown in Fig. 1 an analog signal transmitted by a transmitter (not shown) is received wire-lessly 1 and it is subsequently analog-to-digital converted 2. The digitized signal is down-sampled 3 to reduce the complexity of the subsequent processing. The signal may be band pass filtered before the down-sampling to eliminate aliasing caused by the down-sampling.

By multiplication with a local code, e.g. the C/A code of GPS, the signal is subject to code stripping 4. The signal is then passed through a filtering block 5 to enhance the signal-to-noise ratio of the signal, in particular, the carrier. The filtered signal is the input signal $x_{in}(n)$ that is to be processed further. In the context of a GPS environment it is the aim to estimate the carrier frequency accurately.

In the following as an illustrative embodiment of the disclosed method using an iterative procedure for estimating the frequency $f_x$ of the input signal is described. As shown in Fig. 2 the input signal $x_{in}$ is subject to a Fast Fourier Transform (FFT). Subsequently, the frequency Max(f) of the maximum of the transformed signal is searched for. If $f_{ac}$ represents the frequency estimated by some pre-stage acquisition means (rough estimate for $f_x$) or selected a priori and if the size of the acquisition frequency bin is, e.g., 500 Hz, the search for the peak in the Fourier spectrum is restricted to the interval [$f_{ac}$ - 500 Hz, $f_{ac}$ + 500 Hz]. The determined frequency that corresponds to the peak represents the first estimate $\hat{f}_{x,0}$ for the frequency $f_x$.

For the i-th iteration of the employed procedure a vector $\mathbf{x}_i$ containing N samples of the input signal and a vector $\mathbf{x}_{L,i}$ containing N samples time-delayed by the integer L with respect to the first samples are to be defined. The respective first vectors read

$$\mathbf{x}_1 = (x_{in}(0), x_{in}(1), .., x_{in}(N-1)) \text{ and } \mathbf{x}_{1,L} = (x_{in}(L), x_{in}(L+1), .., x_{in}(L+N-1)).$$

Next, the vectors are subject to a Discrete Time Fourier Transform evaluated in the form

$$X_1(f) = \sum_{n=0}^{N-1} x_{in}(n)\exp(-i2\pi f n) \text{ and } X_2(f) = \sum_{n=0}^{N-1} x_{in}(n+L)\exp(-i2\pi f n), \text{ respectively.}$$

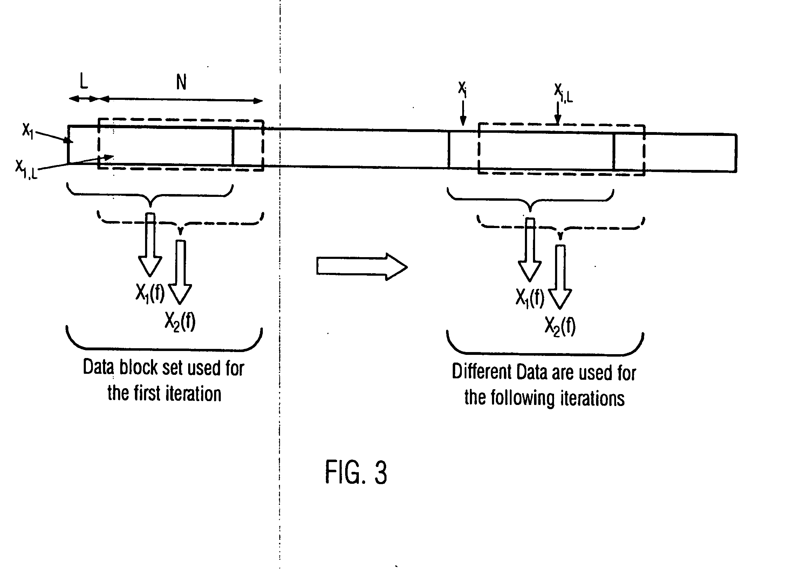

The data blocks used for the first as well as the i-th iteration are illustrated in Fig. 3. The data blocks represented by $\mathbf{x}_1$ and $\mathbf{x}_{1,L}$ overlap each other due to the fact that the time-delay L is lower than N. The same holds for the vectors $\mathbf{x}_i$ and $\mathbf{x}_{i,L}$. used in subsequent iterations. For simplicity, the respective DTFTs are denoted by $X_1$ and $X_2$ for each iteration whereas they are based on different data blocks for each of the iterations.

The ratio of $X_2$ and $X_1$ can be obtained as

$$r(f) := m_r(f)\exp(i\varphi_r(f)) = \frac{a \exp(i2\pi f_x L)D(f - f_x) + a^* \exp(-i2\pi f_x L)D(f + f_x)}{aD(f - f_x) + a^* D(f + f_x)}$$

where D(f) = sin($\pi$ f N) / sin($\pi$f) and a = exp(i($\varphi$ + $\pi f_x$(N - 1))) and the asterisk denotes the conjugate complex.

The phase $\varphi_r(f)$ of the ratio r(f) is actually used to estimate $f_x$. One should note that D(0) = N and that D(2 $f_x$) is negligible as compared to D(0) and even equals zero, if $f_x$ = k / N, where k is an integer. Furthermore, if $f_x$ = k / N, r($f_x$) = $m_r(f)\exp(i\varphi_r(f))$ = exp(i2$\pi f_x$L). Consequently, the fixed point mapping

$$g(f_x, f_x) = \frac{\varphi_r(f_x)}{2\pi L} = f_x$$

holds at least in good approximation. The solution of the fixed point mapping is obtained by the iteration $\hat{f}_{x,i+1} = g(\hat{f}_{x,i}, f_x)$, where the circumflex indicates the estimate of the respective iteration step i. As mentioned above the initial value for the iteration $\hat{f}_{x,0}$ is obtained by means of an FFT of the input signal $x_{in}$. At the i-th iteration the DTFTs of $x_i$ and $x_{L,i}$ are evaluated for f = $\hat{f}_{x,i-1}$ ($\hat{f}_{x,i-1}$ being the value of the estimate for $f_x$ at the (i - 1) iteration). Subsequently, the ratio DTFT ($\mathbf{x}_{L,i}$) / DTFT($\mathbf{x}_i$) at f = $\hat{f}_{x,i-1}$ and the phase $\varphi_{r,i}$ (f) are calculated from which the new frequency estimation results as

$$\hat{f}_{x,i} = \frac{\varphi_{r,i}}{2\pi L} .$$

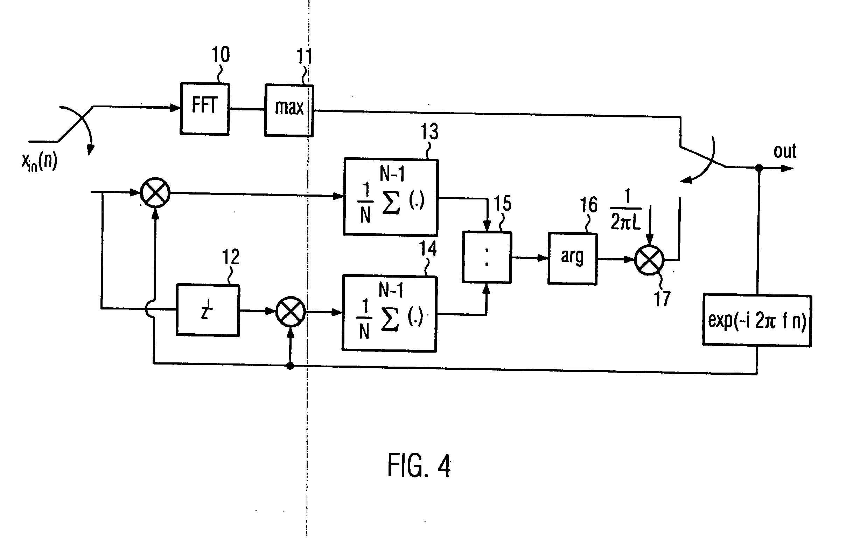

For illustration purposes Fig. 4 shows a flowchart of an example of the disclosed method. The input signal $x_{in}$ (n) is subject to an FFT 10 and the frequency of the peak in the Fourier transformed spectrum is determined 11. On the other hand, sample vectors $\mathbf{x}_i$ and $\mathbf{x}_{L,i}$ that is time-delayed 12 by L with respect to $\mathbf{x}_i$ are defined and respectively subject to a DTFT 13 and 14 as described above. The ratio 15 and the phase 16 of the ratio of the DTFTs $X_2$ and $X_1$ are calculated. By means of the phase the above mentioned fixed point mapping is built. At the end of the iteration process the finally estimated frequency is output. The output signal of the thus constituted Frequency Lock Loop can be used, e.g., for tracking of the carrier frequency of a GPS signal.

Due to the elimination of multiples of $2\pi$ the problem of phase ambiguities arises when employing the DTFT. This problem can be solved by adding a correction term to the estimated frequency, in particular, by adding a term round $(\hat{f}_{x,0} L)$ that takes into account the integer number of $2\pi$ - number of cycles. Thus, the output signal can be generated including such a correction term. In addition, depending on the convergence properties of the iteration procedure each iteration estimate may be buffered and sorted and the center value of the estimated frequencies might be chosen for the output signal. Mean values of estimated frequencies taken over different time periods may also be used to generate the output signal.

It is noted that from the DTFTs 13 and 14 the maximum likelihood phases of the vectors $\mathbf{x}_i$ and $\mathbf{x}_{L,i}$ can directly be determined. These phases can alternatively be used for the determination of the desired frequency estimate, since

$$\hat{f}_{x,i+1} = \frac{1}{2\pi L} \text{angle}\{ X_1(\hat{f}_{x,i}) / X_2(\hat{f}_{x,i})\}$$

$$= \frac{1}{2\pi L} [\text{angle}\{ X_1(\hat{f}_{x,i})\} - \text{angle}\{ X_2(\hat{f}_{x,i})\} ] = \frac{1}{2\pi L} (\hat{\varphi}_{2,i} - \hat{\varphi}_{1,i})$$

with

$$\hat{\varphi}_{1,i} = \text{angle}\{ \text{DTFT}_N \{\mathbf{x}_i |_{f=\hat{f}_{x,i}}\} \text{ and } \hat{\varphi}_{2,i} = \text{angle}\{ \text{DTFT}_N \{\mathbf{x}_{L,i} |_{f=\hat{f}_{x,i}}\}.$$

Thus, instead of the above-described fixed point mapping the above kind of iteration making use of the maximum-likelihood phase estimations can be incorporated in the inventive method and apparatus.

As it is known in the art, in practice, the DTFT phases can be obtained by performing an arctan2 over the Discrete Time Fourier transformed data segments vectors $\mathbf{x}_i$ and $\mathbf{x}_{L,i}$, where

$$\text{arctan}_2 (b,a) = \text{arctan}(b/a) , \text{ if } a > 0, \text{ or arctan}_2 (b,a) = \text{arctan}(b/a) + \pi, \text{ if } a < 0.$$

**Claims**

1. Method for estimating the frequency ($f_x$) of a periodic input signal ($x_{in}$), comprising
   performing a Discrete Time Fourier Transform of N first time-discrete samples (x) of the input signal ($x_{in}$), N being an integer $\geq 1$, to obtain a first transformed signal ($X_1$);
   performing a Discrete Time Fourier Transform of N second time-discrete samples ($\mathbf{x}_L$) of the input signal ($x_{in}$) time-delayed by L samples with respect to the first time-discrete samples ($\mathbf{x}$), L being an integer $\geq 1$, to obtain a second transformed signal ($X_2$);
   calculating the phase ($\varphi_r$) of the ratio (r) of the second transformed signal ($X_2(f)$) and the first transformed signal ($X_1(f)$) at one single pre-selected frequency (f);

determining an estimate $(\hat{f}_x)$ for the frequency $(f_x)$ of the periodic input signal $(x_{in})$ on the basis of the phase $(\varphi_r)$ of the ratio of the second transformed signal $(X_2(f))$ and the first transformed signal $(X_1(f))$ at the pre-selected frequency $(f)$; and

generating an output signal on the basis of the estimate $(\hat{f}_x)$ for the frequency $(f_x)$.

2. The method according to claim 1, wherein the estimate $(\hat{f}_x)$ for the frequency $(f_x)$ of the periodic input signal $(x_{in})$ is iteratively calculated and the output signal is generated on the basis of the iteratively calculated values for $\hat{f}_x$.

3. The method according to claim 2, wherein the frequency $(f_x)$ of the periodic input signal $(x_{in})$ is estimated by the solution of a fixed point mapping $g(f_x, \ f_x) = \dfrac{\varphi_r(f_x)}{2\pi \ L} = f_x$, where $\varphi_r$ denotes the phase of the ratio of the second transformed signal $(X_2(f))$ and the first transformed signal $(X_1(f))$ at the pre-selected frequency $(f)$ and the output signal is generated on the basis of the solution of the fixed point mapping .

4. The method according to claim 2 or 3, wherein the frequency $(f_x)$ of the periodic input signal $(x_{in})$ is estimated by a fixed point iteration according to $\hat{f}_{x,i+1} = g(\hat{f}_{x,i}, f_x)$, where $\hat{f}_{x,i}$ denotes the i-th estimate, $i \geq 0$, for the frequency $(f_x)$ of the periodic input signal $(x_{in})$.

5. The method according to one of the claims 2 - 4, wherein the first estimate of the iteration $(\hat{f}_{x,0})$ for estimating the frequency $(f_x)$ of the periodic input signal $(x_{in})$ is calculated by a Fast Fourier Transform.

6. The method according to claim 5, wherein the first estimate of the iteration $(\hat{f}_{x,0})$ for the frequency $(f_x)$ of the periodic input signal $(x_{in})$ is calculated by seeking for the peak of the Fast Fourier Transform in an interval ranging from one acquisition frequency bin below a rough estimate for the frequency $(f_x)$ of the periodic input signal $(x_{in})$ to one acquisition frequency bin above the rough estimate for the frequency $(f_x)$ of the periodic input signal $(x_{in})$.

7. The method according to one of the claims 2 to 6, further comprising comparing the estimated frequency $\hat{f}_x$ as well as $\hat{f}_x - \Delta$ and $\hat{f}_x + \Delta$, where $\Delta$ denotes some frequency leap, with a rough estimate for the frequency $(f_x)$ of the periodic input signal $(x_{in})$ or with the first estimate of the iteration $(\hat{f}_{x,0})$ for the frequency $(f_x)$ of the periodic input signal $(x_{in})$ and generating the output signal on the basis of the comparison result.

8. The method according to one of the claims 2 - 7, wherein for i iterations, $i \geq 2$,

i ratios of respective second transformed signals $(X_{L,i}(f))$ obtained by Discrete Time Fourier Transforms of N second time-discrete samples $(\mathbf{x}_{L,i})$ delayed by L samples with respect to N first time-discrete samples $(\mathbf{x}_i)$ and respective first transformed signals $(X_i(f))$ obtained by Discrete Time Fourier Transforms of N first time-discrete samples $(\mathbf{x}_i)$ for a frequency that is equal to the estimation $(\hat{f}_{x,i-1})$ of the frequency $(f_x)$ of the periodic input signal $(x_{in})$ at the (i - 1) - th iteration and i phase values $(\varphi_{r,i})$ for the respective i ratios are calculated, and

an i-th frequency estimation $(\hat{f}_{x,i})$ is calculated by $\hat{f}_{x,i} = \dfrac{\varphi_{r,i}}{2\pi L}$, which subsequently

is used for the i+1-th frequency estimation $(\hat{f}_{x,i+1})$ calculated by $\hat{f}_{x,i+1} = g(\hat{f}_{x,i}, f_x)$.

9. The method according to one of the preceding claims, further adding a correction term to the estimated frequency in order to avoid phase ambiguities.

10. The method according to claim 9, wherein the correction term is given by the rounded integer of $2\pi$ - number of cycles to the estimated frequency $(\hat{f}_x ; \hat{f}_{x,i})$ in order to avoid phase ambiguities.

11. The method according to one of the claims 2 - 10, further comprising sorting a pre-selected number of iteratively

calculated estimates $(\hat{f}_{x,i})$ for the frequency $(f_x)$ of the periodic input signal $(x_{in})$ and generating the output value on the basis of the center value of the sorted estimates $(\hat{f}_{x,i})$.

12. The method according to one of the preceding claims, further comprising determining a mean value over a pre-selected time period of iteratively calculated estimates $(\hat{f}_{x,i})$ for the frequency $(f_x)$ of the periodic input signal $(x_{in})$.

13. The method according to claim 12, further comprising filtering values of iteratively calculated estimates $(\hat{f}_{x,i})$ for the frequency $(f_x)$ of the periodic input signal $(x_{in})$ by a median filter, wherein the filtering comprises sorting a pre-selected number of values taken over pre-selected time periods of iteratively calculated estimates $(\hat{f}_{x,i})$ for the frequency $(f_x)$ of the periodic input signal $(x_{in})$ before the step of determining the mean value.

14. The method according to one of the above claims, further comprising
determining the maximum likelihood estimation for the phase $\hat{\varphi}_{1,i}$ of the first time-discrete samples $(x)$ of the input signal $(x_{in})$;
determining the maximum likelihood estimation for the phase $\hat{\varphi}_{2,i}$ of the second time-discrete samples $(x_L)$ of the input signal $(x_{in})$;
and wherein the i+1-th estimate for the frequency is determined according to

$$\hat{f}_{x,i+1} = \frac{1}{2\pi L}(\hat{\varphi}_{2,i} - \hat{\varphi}_{1,i})$$

where $\hat{\varphi}_{1,i}$ and $\hat{\varphi}_{2,i}$ are the angles of the Discrete Time Fourier Transform of the first and second time-discrete samples $(x)$ of the input signal $(x_{in})$ for the frequency $f=\hat{f}_{x,i}$, respectively.

15. The method according to one of the preceding claims, further filtering the input signal $(x_{in})$ by means of a noise reduction filtering means before performing the Discrete Time Fourier Transform of the N first time-discrete samples $(\mathbf{x})$.

16. The method according to one of the preceding claims, further down-sampling the periodic input signal $(x_{in})$ before performing the Discrete Time Fourier Transform of the N first time-discrete samples $(\mathbf{x})$.

17. The method according to claim 16, further comprising filtering the down-sampled input signal $(x_{in})$ by means of a noise reduction filtering means before performing the Discrete Time Fourier Transform of the N first time-discrete samples $(\mathbf{x})$.

18. The method according to claim 16 or 17, further comprising bandpass anti-aliasing filtering the pre-down-sampled input signal $(x_{in})$.

19. The method according to one of the preceding claims, wherein $N \geq L$.

20. The method according to one of the preceding claims, wherein the input signal $(x_{in})$ is based on a signal generated by and received from a GPS satellite and further comprising stripping of the C/A code and/or the P code before performing the Discrete Time Fourier Transform of the N first time-discrete samples $(\mathbf{x})$.

21. The method according to claim 20, further comprising filtering the estimate $(\hat{f}_x)$ for the frequency $(f_x)$ of the periodic input signal $(x_{in})$ by a Kalman filter to obtain a Kalman filtered frequency and wherein the output signal is generated on the basis of the Kalman filtered frequency.

22. The method according to claim 21, wherein the Kalman filtered frequency is obtained from the evolution model

$$\begin{bmatrix} \nu \\ \Delta\nu \end{bmatrix}_{i+1} = \begin{bmatrix} 1 & 1 \\ 0 & 1 \end{bmatrix}\begin{bmatrix} \nu \\ \Delta\nu \end{bmatrix}_i + \mathbf{w}_i$$

and

$$\hat{f}_x = [1 \; 0]\begin{bmatrix} \nu \\ \Delta\nu \end{bmatrix}_i + \mathbf{v}_i$$

with the Doppler rates $\Delta\nu$ accounting for linear frequency variations and where $\mathbf{w}_i$ denotes noise contribution and random variation of the Doppler rate and $\mathbf{v}_i$ denotes a noise component due to estimation errors.

23. A data acquisition apparatus, comprising
receiving means configured to receive a periodic input signal ($x_{in}$);
a central processing unit configured to perform the calculations of the method of one of the preceding claims and to determine an estimate ($\hat{f}_x$) for the frequency ($f_x$) of the periodic input signal ($x_{in}$) on the basis of the phase ($\varphi_r$) of the ratio of a calculated Discrete Time Fourier Transform of N time-discrete samples ($\mathbf{x}_L$) of the input signal ($x_{in}$) time-delayed by L samples with respect to the first time-discrete samples ($\mathbf{x}$), L being an integer $\geq 1$, and a calculated Discrete Time Fourier Transform of first time-discrete samples (x) of the input signal ($x_{in}$), N being an integer $\geq 1$;
output means configured to output an output signal based on the estimate ($\hat{f}_x$) for the frequency ($f_x$) of the periodic input signal ($x_{in}$); and
signal tracking means configured to track the input signal ($x_{in}$) on the basis of the output signal.

24. Apparatus according to claim 23, further comprising
first filtering means configured to reduce noise of a noisy input signal ($x_{in}$);
means configured to down-sample the input signal ($x_{in}$);
second filtering means configured to low-pass filter the down-sampled input signal.

25. Apparatus according to claim 23 or 24, further comprising a Kalman filtering means, configured to filter the estimate ($\hat{f}_x$) for the frequency ($f_x$) of the periodic input signal ($x_{in}$).

26. Apparatus according to one of the claims 23 - 25, wherein the apparatus comprises a receiver, in particular a Global Positioning System receiver, or a frequency synthesizer for digitally tuned radio receivers and transmitters or a decoder for remote control and telecommunications.

27. Navigation system for a vehicle, comprising an apparatus according to one of the claims 23 - 26.

28. Computer program product, comprising one or more computer readable media having computer-executable instructions for performing the steps of the method according to one of the Claims 1 - 22.

**Patentansprüche**

1. Verfahren zum Schätzen der Frequenz ($f_x$) eines periodischen Eingangssignals ($x_{in}$), das umfasst:

Durchführen einer zeitdiskreten Fourier-Transformation N erster zeitdiskrete Abtastwerte (x) des Eingangssignals ($x_{in}$), um ein erstes transformiertes Signal ($X_1$) zu ermitteln, wobei N eine ganze Zahl $\geq 1$ ist;
Durchführen einer zeitdiskreten Fourier-Transformation N zweiter zeitdiskreter Abtastwerte ($x_L$) des Eingangssignals ($x_{in}$), die in Bezug auf die ersten zeitdiskreten Abtastwerte (x) um L Abtastwerte zeitverzögert sind, um ein zweites transformiertes Signal ($X_2$) zu ermitteln, wobei L eine ganze Zahl $\geq 1$ ist;
Berechnen der Phase ($\varphi_r$) des Verhältnisses (r) des zweiten transformierten Signals ($X_2(f)$) und des ersten

transformierten Signals ($X_1(f)$) bei einer einzelnen vorausgewählten Frequenz (f);
Bestimmen eines Schätzwertes ($\hat{f}_x$) für die Frequenz ($f_x$) des periodischen Eingangssignals ($x_{in}$) auf Basis der Phase ($\varphi_r$) des Verhältnisses des zweiten transformierten Signals ($X_2(f)$) und des ersten transformierten Signals ($X_1(f)$) bei der vorausgewählten Frequenz (f); und
Erzeugen eines Ausgangssignals auf Basis des Schätzwertes ($\hat{f}_x$) für die Frequenz ($f_x$).

2. Verfahren nach Anspruch 1, wobei der Schätzwert ($\hat{f}_x$) für die Frequenz ($f_x$) des periodischen Eingangssignals ($x_{in}$) iterativ berechnet wird und das Ausgangssignal auf Basis der iterativ berechneten Werte für $\hat{f}_x$ erzeugt wird.

3. Verfahren nach Anspruch 2, wobei die Frequenz ($f_x$) des periodischen Eingangssignals ($x_{in}$) mittels der Lösung eines Fixpunkt-Mapping $g(f_x, f_x) = \dfrac{\varphi_r(f_x)}{2\pi \, L} = f_x$ geschätzt wird, $\varphi_r$ die Phase des Verhältnisses des zweiten transformierten Signals ($X_1(f)$) und des ersten transformierten Signals ($X_1(f)$) bei der vorausgewählten Frequenz (f) bezeichnet und das Ausgangssignal auf Basis der Lösung des Fixpunkt-Mapping erzeugt wird.

4. Verfahren nach Anspruch 2 oder 3, wobei die Frequenz ($f_x$) des periodischen Eingangssignals ($x_{in}$) mittels einer Fixpunkt-Iteration gemäß $\hat{f}_{x,i+1} = g(\hat{f}_{x,i}, f_x)$ geschätzt wird, wobei $\hat{f}_{x,i}$ den i-ten Schätzwert, für die Frequenz ($f_x$) des periodischen Eingangssignals ($x_{in}$) bezeichnet, und $i \geq 0$.

5. Verfahren nach einem der Ansprüche 2-4, wobei der erste Schätzwert der Iteration ($\hat{f}_{x,0}$) zum Schätzen der Frequenz ($f_x$) des periodischen Eingangssignals ($x_{in}$) mittels einer schnellen Fourier-Transformation berechnet wird.

6. Verfahren nach Anspruch 5, wobei der erste Schätzwert der Iteration ($\hat{f}_{x,0}$) für die Frequenz ($f_x$) des periodischen Eingangssignals ($x_{in}$) berechnet wird, indem nach dem Maximum der schnellen Fourier-Transformation in einem Intervall gesucht wird, das von einem Erfassungsfrequenz-Bin unterhalb eines groben Schätzwertes für die Frequenz ($f_x$) des periodischen Eingangssignals ($x_{in}$) bis zu einem Erfassungsfrequenz-Bin oberhalb des groben Schätzwertes für die Frequenz ($f_x$) des periodischen Eingangssignals ($x_{in}$) reicht.

7. Verfahren nach einem der Ansprüche 2 bis 6, das des Weiteren Vergleichen der geschätzten Frequenz $\hat{f}_x$ sowie von $\hat{f}_x - \Delta$ und $\hat{f}_x + \Delta$ mit einem groben Schätzwert für die Frequenz ($f_x$) des periodischen Eingangs ($x_{in}$) oder mit dem ersten Schätzwert der Iteration ($\hat{f}_{x,0}$) für die Frequenz ($f_x$) des periodischen Eingangssignals ($x_{in}$) sowie Erzeugen des Ausgangssignals auf Basis des Vergleichsergebnisses umfasst, wobei $\Delta$ einen Frequenzsprung bezeichnet.

8. Verfahren nach einem der Ansprüche 2-7, wobei für i Iterationen, wenn $i \geq 2$, i Verhältnisse jeweiliger zweiter transformierter Signale ($X_{L,i}(f)$), die mittels zeitdiskreter Fourier-Transformationen N zweiter zeitdiskreter Abtastwerte ($x_{L,i}$) ermittelt werden, die um L Abtastwerte in Bezug auf N erste zeitdiskrete Abtastwerte ($x_i$) verzögert sind, und jeweiliger erster transformierter Signale ($X_i(f)$), die mittels zeitdiskreter Fourier-Transformationen N erster zeitdiskreter Abtastwerte ($x_i$) für eine Frequenz ermittelt werden, die dem Schätzwert ($\hat{f}_{x,i}$) der Frequenz ($f_x$) des periodischen Eingangssignals ($x_{in}$) bei der (i - 1)-ten Iteration gleich ist, und i Phasenwerte ($\varphi_{r,i}$) für die jeweiligen i-Verhältnisse berechnet werden, und

ein i-ter Frequenzschätzwert ($\hat{f}_{x,i}$) mittels $\hat{f}_{x,i} = \dfrac{\varphi_{r,i}}{2\pi \, L}$ berechnet wird, der anschließend für die i+1-te Frequenzschätzung ($\hat{f}_{x,i+1}$) verwendet wird, die mittels $\hat{f}_{x,i+1} = g(\hat{f}_{x,i}, f_x)$ berechnet wird.

9. Verfahren nach einem der vorangehenden Ansprüche, das des Weiteren Addieren eines Korrekturterms zu der geschätzten Frequenz umfasst, um Phasen-Mehrdeutigkeiten zu vermeiden.

10. Verfahren nach Anspruch 9, wobei der Korrekturterm durch die gerundete ganze Zahl von $2\pi$- Anzahl von Zyklen

zu der geschätzten Frequenz $(\hat{f}_x;\hat{f}_{x,i})$ gegeben ist, um Phasen-Mehrdeutigkeiten zu vermeiden.

11. Verfahren nach einem der Ansprüche 2-10, das des Weiteren Sortieren einer vorausgewählten Zahl iterativ berechneter Schätzwerte $(\hat{f}_{x,i})$ für die Frequenz $(f_x)$ des periodischen Eingangssignals $(x_{in})$ und Erzeugen des Ausgangswertes auf Basis des Mittenwertes der sortierten Schätzwerte $(\hat{f}_{x,i})$ umfasst.

12. Verfahren nach einem der vorangehenden Ansprüche, das des Weiteren Bestimmen eines Mittelwertes iterativ berechneter Schätzwerte $(\hat{f}_{x,i})$ für die Frequenz $(f_x)$ des periodischen Eingangssignals $(x_{in})$ über einen vorausgewählten Zeitraum umfasst.

13. Verfahren nach Anspruch 12, das des Weiteren Filtern von Werten iterativ berechneter Schätzwerte $(\hat{f}_{x,i})$ für die Frequenz $(f_x)$ des periodischen Eingangssignals $(x_{in})$ mittels eines Medianfilters umfasst, wobei das Filtern Sortieren einer vorausgewählten Anzahl über vorausgewählte Zeiträume ermittelter Werte iterativ berechneter Schätzungen $(\hat{f}_{x,i})$ für die Frequenz $(f_x)$ des periodischen Eingangssignals $(x_{in})$ vor dem Schritt des Bestimmens des Mittelwertes umfasst.

14. Verfahren nach einem der obenstehenden Ansprüche, das des Weiteren umfasst:

   Bestimmen des Maximum-Likelihood-Schätzwertes für die Phase $\hat{\phi}_{1,i}$ der ersten zeitdiskreten Abtastwerte $(x)$ des Eingangssignals $(x_{in})$;
   Bestimmen des Maximum-Likelihood-Schätzwertes für die Phase $\hat{\phi}_{2,i}$ der zweiten zeitdiskreten Abtastwerte $(x_L)$ des Eingangssignals $(x_{in})$;
   und wobei der i+1-te Schätzwert für die Frequenz gemäß

$$\hat{f}_{x,i+1} = \frac{1}{2\pi L}(\hat{\varphi}_{2,i} - \hat{\varphi}_{1,i})$$

   bestimmt wird, wobei $\hat{\phi}_{1,i}$ und $\hat{\phi}_{2,i}$ die Winkel der zeitdiskreten Fourier-Transformation der ersten bzw. der zweiten zeitdiskreten Abtastwerte $(x)$ des Eingangssignals $(x_{in})$ für die Frequenz $f = \hat{f}_{x,i}$ sind.

15. Verfahren nach einem der vorangehenden Ansprüche, das des Weiteren Filtern des Eingangssignals $(x_{in})$ mittels einer Rauschminderungs-Filtereinrichtung vor dem Durchführen der zeitdiskreten Fourier-Transformation der N ersten zeitdiskreten Abtastwerte $(x)$ umfasst.

16. Verfahren nach einem der vorangehenden Ansprüche, das des Weiteren Verringern der Abtastrate des periodischen Eingangssignals $(x_{in})$ vor Durchführen der zeitdiskreten Fourier-Transformation der N ersten zeitdiskreten Abtastwerte $(x)$ umfasst.

17. Verfahren nach Anspruch 16, das des Weiteren Filtern des Eingangssignals $(x_{in})$ mit verringerter Abtastrate mittels einer Rauschminderungs-Filtereinrichtung vor dem Durchführen der zeitdiskreten Fourier-Transformation der N ersten zeitdiskreten Abtastwerte $(x)$ umfasst.

18. Verfahren nach Anspruch 16 oder 17, das des Weiteren Bandpass-Antialiasing-Filtern des Eingangssignals $(x_{in})$ vor Verringerung der Abtastrate umfasst.

19. Verfahren nach einem der vorangehenden Ansprüche, wobei $N \geq L$.

20. Verfahren nach einem der vorangehenden Ansprüche, wobei das Eingangssignal $(x_{in})$ auf einem Signal basiert, das durch einen GPS-Satelliten erzeugt und von ihm empfangen wird, und das des Weiteren Stripping des C/A-Codes und/oder des P-Codes vor Durchführen der zeitdiskreten Fourier-Transformation der N ersten zeitdiskreten Abtastwerte $(x)$ umfasst.

21. Verfahren nach Anspruch 20, das des Weiteren Filtern des Schätzwertes $(\hat{f}_x)$ für die Frequenz $(f_x)$ des periodischen Eingangssignals $(x_{in})$ mittels eines Kalman-Filters umfasst, um eine Kalman-Filtern unterzogene Frequenz zu ermitteln, und wobei das Ausgangssignal auf Basis der Kalmann-Filtern unterzogenen Frequenz erzeugt wird.

**22.** Verfahren nach Anspruch 21, wobei die Kalman-Filtern unterzogene Frequenz aus dem Evolutionsmodell

$$\begin{bmatrix} v \\ \Delta v \end{bmatrix}_{i+1} = \begin{bmatrix} 1 & 1 \\ 0 & 1 \end{bmatrix} \begin{bmatrix} v \\ \Delta v \end{bmatrix}_i + \mathbf{w}_i$$

und

$$\hat{f}_x = \begin{bmatrix} 1 & 0 \end{bmatrix} \begin{bmatrix} v \\ \Delta v \end{bmatrix}_i + \mathbf{v}_i$$

ermittelt wird, wobei die Doppler-Raten $\Delta v$ lineare Frequenzschwankungen berücksichtigen, $w_i$ Rauschverteilung sowie Zufallsschwankung der Doppler-Rate bezeichnet und $v_i$ eine Rauschkomponente aufgrund von Schätzungsfehlern bezeichnet.

**23.** Datenerfassungsvorrichtung, die umfasst:

eine Empfangseinrichtung, die zum Empfangen eines periodischen Eingangssignals ($x_{in}$) konfiguriert ist;
eine zentrale Verarbeitungseinheit, die so konfiguriert ist, dass sie die Berechnungen des Verfahrens nach einem der vorangehenden Ansprüche durchführt und einen Schätzwert ($\hat{f}_x$) für die Frequenz ($f_x$) des periodischen Eingangssignals ($x_{in}$) auf Basis der Phase ($\varphi_r$) des Verhältnisses einer berechneten zeitdiskreten Fourier-Transformation N zeitdiskreter Abtastwerte ($x_L$) des Eingangssignals ($x_{in}$), die um L Abtastwerte in Bezug auf die ersten zeitdiskreten Abtastwerte (x) zeitverschoben sind, wobei L eine ganze Zahl $\geq 1$ ist, sowie einer berechneten zeitdiskreten Fourier-Transformation erster zeitdiskreter Abtastwerte (x) des Eingangssignals ($x_{in}$) bestimmt, wobei N eine ganze Zahl $\geq 1$ ist;
eine Ausgabeeinrichtung, die so konfiguriert ist, dass sie ein Ausgangssignal auf Basis des Schätzwertes ($\hat{f}_x$) für die Frequenz ($f_x$) des periodischen Eingangssignals ($x_{in}$) ausgibt; und
eine Signalverfolgungseinrichtung, die so konfiguriert ist, dass sie das Eingangssignal ($x_{in}$) auf Basis des Ausgangssignals verfolgt.

**24.** Vorrichtung nach Anspruch 23, die des Weiteren umfasst:

eine erste Filtereinrichtung, die so konfiguriert ist, dass sie Rauschen eines verrauschten Eingangssignals ($x_{in}$) reduziert;
eine Einrichtung, die so konfiguriert ist, dass sie die Abtastrate des Eingangssignals ($x_{in}$) verringert;
eine zweite Filtereinrichtung, die so konfiguriert ist, dass sie das Eingangssignal mit verringerter Abtastrate Tiefpassfiltern unterzieht.

**25.** Vorrichtung nach Anspruch 23 oder 24, die des Weiteren eine Kalmann-Filtereinrichtung umfasst, die so konfiguriert ist, dass sie den Schätzwert ($\hat{f}_x$) für die Frequenz ($f_x$) des periodischen Eingangssignals ($x_{in}$) filtert.

**26.** Vorrichtung nach einem der Ansprüche 23 - 25, wobei die Vorrichtung einen Empfänger, insbesondere einen GPS-Empfänger, oder einen Frequenz-Synthesizer für digital abgestimmte Funkempfänger und -sender oder einen Decoder für Fernsteuerung und Telekommunikation umfasst.

**27.** Navigationssystem für ein Fahrzeug, das eine Vorrichtung nach einem der Ansprüche 23 - 26 umfasst.

**28.** Computerprogrammerzeugnis, das ein oder mehrere computerlesbare/s Medium/Medien umfasst, das/die durch Computer ausführbare Befehle zum Durchführen der Schritte des Verfahrens nach einem der Ansprüche 1 - 22 aufweist/aufweisen.

**Revendications**

1. Procédé pour évaluer la fréquence ($f_x$) d'un signal d'entrée périodique ($x_{in}$), comprenant :

   l'exécution d'une Transformée de Fourier à Temps Discret sur N premiers échantillons en temps discret (x) du signal d'entrée ($x_{in}$), N étant un entier ≥ 1, pour obtenir un premier signal transformé ($X_1$) ;
   l'exécution d'une Transformée de Fourier à Temps Discret sur N seconds échantillons en temps discret ($x_L$) du signal d'entrée ($x_{in}$) retardé dans le temps de L échantillons par rapport aux premiers échantillons en temps discret (x), L étant un entier ≥ 1, pour obtenir un second signal transformé ($X_2$) ;
   le calcul de la phase ($\varphi_r$), du rapport (r) du second signal transformé ($X_2(f)$) et du premier signal transformé ($X_1(f)$) à une unique fréquence présélectionnée (f) ;
   la détermination d'une évaluation ($\hat{f}_x$) pour la fréquence ($f_x$) du signal d'entrée périodique ($x_{in}$) sur la base de la phase ($\varphi_r$) du rapport du second signal transformé ($X_2(f)$) et du premier signal transformé ($X_1f$)) à la fréquence présélectionnée (f) ; et
   la production d'un signal de sortie sur la base de l'évaluation ($\hat{f}_x$) pour la fréquence ($f_x$).

2. Procédé selon la revendication 1, dans lequel l'évaluation ($\hat{f}_x$) pour la fréquence ($f_x$) du signal d'entrée périodique ($x_{in}$) est calculée de façon itérative et le signal de sortie est produit sur la base des valeurs calculées de façon itérative pour $\hat{f}_x$.

3. Procédé selon la revendication 2, dans lequel la fréquence ($f_x$) du signal d'entrée périodique ($x_{in}$) est évaluée par

   la solution d'une application en virgule fixe $g(f_x, \ f_x) \ = \ \dfrac{\varphi_r(f_x)}{2\pi L} \ = \ f_x,$ où $\varphi_r$, désigne la phase du rapport du second signal transformé ($X_2(f)$) et du premier signal transformé ($X_1(f)$) à la fréquence présélectionnée (f) et le signal de sortie est produit sur la base de la solution de l'application en virgule fixe.

4. Procédé selon la revendication 2 ou 3, dans lequel la fréquence ($f_x$) du signal d'entrée périodique ($x_{in}$) est évaluée par une itération en virgule fixe selon $\hat{f}_{x,i+1} = g(\hat{f}_{x,i}, f_x)$, où $\hat{f}_{x,i}$ désigne l'évaluation de rang i, i ≥ 0, pour la fréquence ($f_x$) du signal d'entrée périodique ($x_{in}$).

5. Procédé selon l'une des revendications 2 à 4, dans lequel la première évaluation de l'itération ($\hat{f}_{x,0}$) pour évaluer la fréquence ($f_x$) du signal d'entrée périodique ($x_{in}$) est calculée par une Transformée de Fourier Rapide.

6. Procédé selon la revendication 5, dans lequel la première évaluation de l'itération ($\hat{f}_{x,0}$) pour la fréquence ($f_x$) du signal d'entrée périodique ($x_{in}$) est calculée en recherchant le pic de la Transformée de Fourier Rapide dans une plage allant d'un intervalle de fréquence d'acquisition au-dessous d'une estimation approximative pour la fréquence ($f_x$) du signal d'entrée périodique ($x_{in}$) à un intervalle de fréquence d'acquisition au-dessus de l'estimation approximative pour la fréquence ($f_x$) du signal d'entrée périodique ($x_{in}$).

7. Procédé selon l'une des revendications 2 à 6, comprenant en outre la comparaison de la fréquence évaluée $\hat{f}_x$ aussi bien que $\hat{f}_x - \Delta$ et $\hat{f}_x + \Delta$, où $\Delta$ désigne un certain saut de fréquence, à une estimation approximative pour la fréquence ($f_x$) du signal d'entrée périodique ($x_{in}$) ou à la première évaluation de l'itération ($\hat{f}_{x,0}$) pour la fréquence ($f_x$) du signal d'entrée périodique ($x_{in}$) et la production du signal de sortie sur la base du résultat de comparaison.

8. Procédé selon l'une des revendications 2 à 7, dans lequel pour i itérations, i ≥ 2,
   i rapports de seconds signaux transformés respectifs ($X_{L,i}(f)$) obtenus par des Transformées de Fourier à Temps Discret sur N seconds échantillons en temps discret ($x_{L,i}$) retardés de L échantillons par rapport aux N premiers échantillons en temps discret ($x_i$) et de premiers signaux transformés respectifs ($X_i(f)$) obtenus par des Transformées de Fourier en Temps Discret sur N premiers échantillons en temps discret ($x_i$) pour une fréquence qui est égale à l'évaluation ($\hat{f}_{x,i-1}$) de la fréquence ($f_x$) du signal d'entrée périodique ($x_{in}$) à l'itération de rang (i-1) et i valeurs de phase ($\varphi_{r,i}$) pour les i rapports respectifs sont calculés, et

   une évaluation de fréquence de rang i ($\hat{f}_{x,i}$) est calculée par $\hat{f}_{x,i} \ = \ \dfrac{\varphi_{r,i}}{2\pi L}$ qui est ensuite utilisée pour l'évaluation de fréquence de rang i+1 ($\hat{f}_{x,i+1}$) calculée par $\hat{f}_{x,i+1} = g(\hat{f}_{x,i}, f_x)$

**9.** Procédé selon l'une des revendications précédentes, ajoutant en outre un terme de correction à la fréquence évaluée afin d'éviter des ambiguïtés de phase.

**10.** Procédé selon la revendication 9, dans lequel le terme de correction est donné par l'entier arrondi de $2\pi$ - le nombre de cycles pour la fréquence évaluée ($\hat{f}_x$;$\hat{f}_{x,i}$) afin d'éviter des ambiguïtés de phase.

**11.** Procédé selon l'une des revendications 2 à 10, comprenant en outre le tri d'un nombre présélectionné d'évaluations calculées de façon itérative ($\hat{f}_{x,i}$) pour la fréquence ($f_x$) du signal d'entrée périodique ($x_{in}$) et la production de la valeur de sortie sur la base de la valeur centrale des évaluations triées ($\hat{f}_{x,i}$).

**12.** Procédé selon l'une des revendications précédentes, comprenant en outre la détermination d'une valeur moyenne, sur une période de temps présélectionnée, d'évaluations calculées de façon itérative ($\hat{f}_{x,i}$) pour la fréquence ($f_x$) du signal d'entrée périodique ($x_{in}$).

**13.** Procédé selon la revendication 12, comprenant en outre le filtrage de valeurs d'évaluations calculées de façon itérative ($\hat{f}_{x,i}$) pour la fréquence ($f_x$) du signal d'entrée périodique ($x_{in}$) par un filtre médian, dans lequel le filtrage comprend le tri d'un nombre présélectionné de valeurs prises sur des périodes de temps présélectionnées d'évaluations calculées de façon itérative ($\hat{f}_{x,i}$) pour la fréquence ($f_x$) du signal d'entrée périodique ($x_{in}$) avant l'étape de détermination de la valeur moyenne.

**14.** Procédé selon l'une des revendications précédentes, comprenant en outre :

la détermination de l'évaluation de probabilité maximale pour la phase $\hat{\varphi}_{1,i}$ des premiers échantillons en temps discret ($x$) du signal d'entrée ($x_{in}$) ;
la détermination de l'évaluation de probabilité maximale pour la phase $\hat{\varphi}_{2,i}$ des seconds échantillons en temps discret ($x_L$) du signal d'entrée ($x_{in}$) ;
et dans lequel l'évaluation de rang i+1 pour la fréquence est déterminée selon

$$\hat{f}_{x,i+1} = \frac{1}{2\pi L}(\hat{\varphi}_{2,i} - \hat{\varphi}_{1,i})$$

où $\hat{\varphi}_{1,i}$ et $\hat{\varphi}_{2,i}$ sont les angles de la Transformée de Fourier à Temps Discret respectivement des premiers et seconds échantillons en temps discret ($x$) du signal d'entrée ($x_{in}$), pour la fréquence f = $\hat{f}_{x,i}$.

**15.** Procédé selon l'une des revendications précédentes, comprenant en outre le filtrage du signal d'entrée ($x_{in}$), à l'aide d'un moyen de filtrage par réduction de bruit avant l'exécution de la Transformée de Fourier à Temps Discret sur les N premiers échantillons en temps discret ($x$).

**16.** Procédé selon l'une des revendications précédentes, comprenant en outre l'échantillonnage décroissant du signal d'entrée périodique ($x_{in}$), avant l'exécution de la Transformée de Fourier à Temps Discret sur les N premiers échantillons en temps discret ($x$).

**17.** Procédé selon la revendication 16, comprenant en outre le filtrage du signal d'entrée ($x_{in}$) ayant subi un échantillonnage décroissant à l'aide d'un moyen de filtrage par réduction de bruit avant l'exécution de la Transformée de Fourier à Temps Discret sur les N premiers échantillons en temps discret ($x$).

**18.** Procédé selon la revendication 16 ou 17, comprenant en outre le filtrage passe-bande anti-repliement de spectre du signal d'entrée ($x_{in}$) ayant subi un pré-échantillonnage décroissant.

**19.** Procédé selon l'une des revendications précédentes, dans lequel N $\geq$ L.

**20.** Procédé selon l'une des revendications précédentes, dans lequel le signal d'entrée ($x_{in}$) est basé sur un signal produit par et reçu en provenance d'un satellite GPS et comprenant en outre l'enlèvement du code C/A et/ou du code P avant l'exécution de la Transformée de Fourier à Temps Discret sur les N premiers échantillons en temps discret ($x$).

**21.** Procédé selon la revendication 20, comprenant en outre le filtrage de l'évaluation ($\hat{f}_x$) pour la fréquence ($f_x$) du signal d'entrée périodique ($x_{in}$) par un filtre de Kalman pour obtenir une fréquence filtrée de Kalman et dans lequel le signal de sortie est produit sur la base de la fréquence filtrée de Kalman.

**22.** Procédé selon la revendication 21, dans lequel la fréquence filtrée de Kalman est obtenue à partir du modèle d'évolution

$$\begin{bmatrix} v \\ \Delta v \end{bmatrix}_{i+1} = \begin{bmatrix} 1 & 1 \\ 0 & 1 \end{bmatrix} \begin{bmatrix} v \\ \Delta v \end{bmatrix}_i + w_i$$

et

$$\hat{f}_x = \begin{bmatrix} 1 & 0 \end{bmatrix} \begin{bmatrix} v \\ \Delta v \end{bmatrix}_i + v_i$$

les vitesses de Doppler $\Delta v$ représentant des variations de fréquence linéaires et où $w_i$ désigne la contribution du bruit et la variation aléatoire de la vitesse de Doppler et $v_i$ désigne une composante de bruit en raison d'erreurs d'évaluation.

**23.** Appareil d'acquisition de données, comprenant :

un moyen de réception configuré pour recevoir un signal d'entrée périodique ($x_{in}$) ;
une unité centrale de traitement configurée pour effectuer les calculs du procédé selon l'une des revendications précédentes et pour déterminer une évaluation ($\hat{f}_x$) pour la fréquence ($f_x$) du signal d'entrée périodique ($x_{in}$) sur la base de la phase ($\varphi_r$) du rapport d'une Transformée de Fourier à Temps Discret calculée sur N échantillons en temps discret ($x_L$) du signal d'entrée ($x_{in}$) retardé dans le temps de L échantillons par rapport aux premiers échantillons en temps discret (x), L étant un entier $\geq$ 1, et d'une Transformée de Fourier à Temps Discret calculée sur des premiers échantillons en temps discret (x) du signal d'entrée ($x_{in}$), N étant un entier $\geq$ 1 ;
un moyen de sortie configuré pour sortir un signal de sortie en se basant sur l'évaluation ($\hat{f}_x$) pour la fréquence ($f_x$) du signal d'entrée périodique ($x_{in}$) ; et
un moyen de suivi de signal configuré pour suivre le signal d'entrée ($x_{in}$) sur la base du signal de sortie.

**24.** Appareil selon la revendication 23, comprenant en outre:

un premier moyen de filtrage configuré pour réduire le bruit d'un signal d'entrée bruyant ($x_{in}$) ;
un moyen configuré pour faire subir un échantillonnage décroissant au signal d'entrée ($x_{in}$) ;
un second moyen de filtrage configuré pour soumettre le signal d'entrée ayant subi un échantillonnage décroissant à un filtrage passe-bas.

**25.** Appareil selon la revendication 23 ou 24, comprenant en outre un moyen de filtrage de Kalman, configuré pour filtrer l'évaluation ($\hat{f}_x$) pour la fréquence ($f_x$) du signal d'entrée périodique ($x_{in}$).

**26.** Appareil selon l'une des revendications 23 à 25, dans lequel l'appareil comprend un récepteur, en particulier un récepteur de système mondial de localisation (GPS), ou un synthétiseur de fréquence pour des récepteurs et des émetteurs radio accordés de façon numérique ou un décodeur pour la commande à distance et les télécommunications.

**27.** Système de navigation pour un véhicule, comprenant un appareil selon l'une des revendications 23 à 26.

**28.** Produit formant programme informatique, comprenant un ou plusieurs supports lisibles par ordinateur comportant des instructions pouvant être exécutées par ordinateur pour effectuer les étapes du procédé selon l'une des revendications 1 à 22.

FIG. 1

FIG. 2

$x_{i,L}$

$x_i$

$X_1(f)$ $X_2(f)$

Different Data are used for
the following iterations

N

L

$x_i$

$x_{i,L}$

$X_1(f)$ $X_2(f)$

Data block set used for
the first iteration

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5222843 A